# EUROPEAN PATENT SPECIFICATION

(11) **EP 3 753 037 B1**
(45) Date of publication and mention of the grant of the patent: **30.08.2023**
(21) Application number: 18906566.7
(22) Date of filing: 13.02.2018
(51) Int. Cl.: H01H 71/04, G01R 31/327

(54) **WIRELESS SENSING SYSTEM AND METHOD FOR SWITCHGEAR**
DRAHTLOSES ERFASSUNGSSYSTEM UND VERFAHREN FÜR EINE SCHALTANLAGE
SYSTÈME ET PROCÉDÉ DE DÉTECTION SANS FIL POUR APPAREILLAGE DE COMMUTATION

(43) Date of publication of application: 23.12.2020
(73) Proprietor: ABB Schweiz AG, 5400 Baden (CH)
(72) Inventor: ZHANG, Yibo, Beijing 100085 (CN); LI, Chun, Beijing 100107 (CN); ZHUANG, Zhijian, 361000 Xiamen, Fujian, (CN); CHEN, Jiansheng, Beijing 100024 (CN); MENG, Delun, Beijing 100015 (CN); TAO, Zhiqiang, Beijing 100085 (CN)
(74) Representative: Zimmermann & Partner Patentanwälte mbB
(86) International application number: PCT/CN2018/076620
(87) International publication number: WO 2019/157622

(56) References cited:
- CN-A- 102 683 098
- CN-A- 102 683 098
- CN-A- 104 142 191
- CN-A- 104 142 191
- CN-A- 105 788 975
- CN-U- 202 678 191
- CN-U- 202 678 191
- CN-U- 204 142 388
- CN-U- 204 142 388
- DE-A1-102015 100 399
- US-A1- 2006 119 344
- US-A1- 2006 119 344

## Description

### FIELD

Embodiments of the present disclosure generally relates to wireless sensing system and method for a switchgear.

### BACKGROUND

With people's increasing demands for electrical power, safeties of electrical power systems become more and more important. Switchgears, such as primary switchgears, are generally utilized as protection equipment for the electrical power systems. In order to ensure normal functions of the switchgear for the electrical power system, it is desirable to monitor operating parameters of the switchgear.

Several kinds of sensors can be applied to the switchgear to sense the operating parameter, such as a temperature. Type and arrangement of the sensor affect sensing accuracy and safety of the sensor, which in turn affect monitoring reliability and safety for the switchgear. A type of sensor which is powered by an external source outside the switchgear has been proposed. This kind of sensor utilizes a power supply from the external source to sense the operating parameter of the switchgear. However, in a case where the power supply from the external source becomes unstable, the sensing accuracy of the sensor will be reduced, and thus the monitoring reliability for the switchgear will be lowered. On the other hand, the arrangement of the sensor may involve installation and readout of the sensor. Patent application US 2006/0119344 A1 discloses a self-powered wireless power bus temperature sensor device disposed about a power bus bar. The sensor device includes a housing, such as an insulated enclosure, and two power coils. The sensor device further includes a temperature sensor that is thermally coupled with a planar surface of the power bus bar.

Another known type of sensor is embedded in a component such as contact arm of the switchgear. However, such a placement of the sensor may cause a change in structure of the switchgear and is adverse to a replacement of the sensor. In addition, sensed data is required to be read out from the sensor within the switchgear in such a way that the obtained data is reliable and the switchgear has lower safety risk in its internal portion.

In order to improve the monitoring reliability and the safety for the switchgear, it is desirable to provide an improved arrangement of a suitable sensor without altering a structure of the switchgear. US2006119344A1 discloses a wireless system for one or more electrical switching apparatuses such as circuit breakers.

### SUMMARY

Embodiments of the present disclosure provide wireless sensing system and method for the switchgear, which improve the monitoring reliability for the switchgear and lower the safety risk of the switchgear.

In a first aspect, embodiments of the present disclosure provide a wireless sensing system for a switchgear, according to the features of claim 1.

In conventional solutions, a sensing system for the current of the switchgear is powered up by an external source which is unstable. Compared with the traditional sensing systems, by powering the first set of one or more wireless sensors of the wireless sensing system with internal sources, embodiments of present disclosure facilitate more reliable monitoring of the current of the circuit breaker with a low safety risk. Moreover, the sensed current of the circuit breaker is read via the wireless communication that is not likely to be influenced by the environment in the compartment. In this way, the switchgear can be monitored in a more reliable manner, thereby ensuring the safety of the switchgear. Additionally, the monitoring can be done without altering the infrastructure of the switchgear.

In some embodiments, each of the first set of one or more wireless sensors comprises: a current sensing module configured to sense the current of the circuit breaker to generate an AC current signal; a signal processing module configured to generate a DC current or voltage signal based on the AC current signal; and a wireless sensor module configured to generate the first sensor signal based on the DC current or voltage signal.

In some embodiments, each of the first set of one or more wireless sensors comprises: a current sensing module configured to sense the current of the circuit breaker to generate a current signal; a signal processing module configured to generate a resistance or inductance signal based on the current signal; and a wireless sensor module configured to generate the first sensor signal based on the resistance or inductance signal.

In some embodiments, each of the first set of one or more wireless sensors comprises: a current sensing module configured to sense the current of the circuit breaker to generate a sensed signal; and a wireless sensor module configured to generate the first sensor signal based on the sensed signal.

In some embodiments, each of the first set of one or more wireless sensors comprises a passive wireless sensor. In this way, compared with current sensors powered up in an active way in the known solutions, the wireless sensors of the wireless sensing system according to embodiments of the present disclosure may be powered up in a passive way by corresponding antennas included in the wireless sensing system. Further, the wireless sensor does not have a power source circuit but uses energy harvesting by wireless radio frequency power instead. The monitoring is not likely to be influenced by variations of the power source, thereby providing a more reliable monitoring of the current of the circuit breaker with a low safety risk.

In some embodiments, the wireless sensing system further comprises: a second set of one or more wireless sensors provided in the first compartment and mounted to a fix contact of the circuit breaker, the second set of one or more wireless sensors being configured to sense a temperature of the fix contact to generate a second sensor signal representing the temperature of the fix contact, wherein the antenna is further configured to receive the second sensor signal from the first set of one or more wireless sensors. In this way, embodiments of present disclosure may further improve monitoring reliability for the switchgear and ensure the safety of the switchgear based on a more reliable monitoring of the temperature of the circuit breaker with a low safety risk.

In some embodiments, the switchgear is monitored based on the first sensor signal and the second sensor signal. In this way, the switchgear is monitored based on a more comprehensive aspect regarding the current and the temperature of the circuit breaker to improve the monitoring reliability and the monitoring accuracy for the switchgear.

In some embodiments, the switchgear further comprises a second compartment, and the wireless sensing system further comprises: a reader provided in the second compartment and configured to receive the first sensor signal and the second sensor signal from the antenna.

In some embodiments, the second set of one or more wireless sensors is mounted to the fix contact by a sensor holder, and the sensor holder comprises a ring shaped hard structure and comprises at least one groove for placing the second set of one or more wireless sensors at a surface of the sensor holder facing the fix contact.

In some embodiments, the antenna comprises a first sub-antenna, a second sub-antenna, and a third sub-antenna for receiving the sensor signals for three phases of the switchgear, respectively.

In some embodiments, the wireless sensor comprises a radio frequency identification (RFID) sensor.

(Canceled)

In conventional solutions, a sensing system for the temperature of the switchgear is powered up by an external source which is unstable. Compared with the traditional sensing systems, by powering the first set of one or more wireless sensors of the wireless sensing system with internal sources, embodiments of present disclosure facilitate more reliable monitoring of the temperature of the circuit breaker with a low safety risk. Moreover, the sensed temperature of the circuit breaker is read via the wireless communication that is not likely to be influenced by the environment in the compartment. In this way, the switchgear can be monitored in a more reliable manner, thereby ensuring the safety of the switchgear. Additionally, the monitoring can be done without altering the infrastructure of the switchgear.

Further, compared with the traditional sensing system without the above configuration of the sensor holder, embodiments of present disclosure may provide a stable and improved coupling between the wireless sensor and the fix contact, thereby improving monitoring reliability and accuracy.

In some embodiments, the sensor holder comprises at least one groove for placing the first set of one or more wireless sensors at a surface of the sensor holder facing the fix contact. In this way, the sensor holder supports the first set of one or more wireless sensors in contact with the fix contact, thereby ensuring a stable installation of the first set of one or more wireless sensors to the fix contact, and improving a thermal coupling between the first set of one or more wireless sensors and the fix contact.

In some embodiments, the sensor holder comprises a ring shaped hard structure that has an inner diameter matching with an outer diameter of the fix contact. In this way, a sliding fit is ensured between the wireless sensor and the fix contact, thereby improving the installation of the first set of one or more wireless sensors to the fix contact without altering the structure of the circuit breaker.

In some embodiments, the wireless sensing system further comprises: a thermal conductive coating provided between the fix contact and the first set of one or more wireless sensors for reducing a thermal resistance between the fix contact and the first set of one or more wireless sensors.

In some embodiments, the wireless sensing system further comprises: a field grading layer provided on at least one of surfaces of the first set of one or more wireless sensors facing the sensor holder or an outer surface of the sensor holder for shielding the first set of one or more wireless sensors. In this way, the first set of one or more wireless sensors are shield by the field grading layer, thereby improving the reliability of the wireless sensors and improving the accuracy of the measurement.

In some embodiments, the first antenna comprises a first sub-antenna, a second sub-antenna, and a third sub-antenna for receiving the first sensor signals for three phases of the switchgear, respectively.

In some embodiments, the switchgear further comprises a second compartment and a bus bar provided in the second compartment, and the wireless sensing system further comprises: a second set of one or more wireless sensors provided in the second compartment and mounted to the bus bar, the second set of one or more wireless sensors being configured to sense a second temperature of the bus bar to generate a second sensor signal representing the second temperature; and a second antenna provided in the second compartment and configured to receive the second sensor signal from the second set of one or more wireless sensors. In this way, embodiments of present disclosure may further facilitate a more reliable monitoring of the temperature of the bus bar with a low safety risk.

In some embodiments, the second antenna is further configured to receive the first sensor signal from the first set of one or more wireless sensors. In this way, not only the first antenna but also the second antenna may receive the first sensor signal, thereby obtaining more samples of the sensed signals and improving the sensing accuracy of the circuit breaker.

In some embodiments, the switchgear further comprises a third compartment and a cable connection provided in the third compartment, and the wireless sensing system further comprises: a third set of one or more wireless sensors provided in the third compartment and mounted to the cable connection, the third set of one or more wireless sensors being configured to sense a third temperature of the cable connection to generate a third sensor signal representing the third temperature; and a third antenna provided in the third compartment and configured to receive the third sensor signal from the third set of one or more wireless sensors. In this way, embodiments of present disclosure may further facilitate a more reliable monitoring of the temperature of the cable connection with a low safety risk.

In some embodiments, the switchgear further comprises a fourth compartment, and the wireless sensing system further comprises: a reader provided in the fourth compartment and configured to receive the sensor signals from the first antenna, the second antenna, and the third antenna. In this way, the desired parameters may be easily obtained from the reader in the fourth compartment, thereby facilitating the monitoring for the switchgear.

In some embodiments, the wireless sensing system further comprises: a fourth set of one or more wireless sensors provided in the first compartment and mounted to tulips of the circuit breaker, the fourth set of one or more wireless sensors being configured to sense a fourth temperature of the tulips of the circuit breaker to generate a fourth sensor signal representing the fourth temperature, wherein the first antenna is further configured to receive the fourth sensor signal from the fourth set of one or more wireless sensors. In this way, the temperature measurements at more points of the circuit breaker may be obtained in the more reliable way, thereby improving the monitoring reliability and the monitoring accuracy for the switchgear.

In some embodiments, the wireless sensing system further comprises: a fifth set of one or more wireless sensors provided in the first compartment and configured to sense a current of the circuit breaker to generate a fifth sensor signal representing the current of the circuit breaker, wherein the first antenna is further configured to receive the fifth sensor signal from the fifth set of one or more wireless sensors. In this way, the wireless sensing system may further improve monitoring reliability for the switchgear and ensure the safety of the switchgear based on a more reliable monitoring of the current of the circuit breaker with a low safety risk.

In some embodiments, the switchgear is monitored based at least on the first sensor signal and the fifth sensor signal. In this way, the switchgear is monitored based on a more comprehensive aspect regarding the temperature and the current of the circuit breaker to improve the monitoring reliability and the monitoring accuracy for the switchgear.

In some embodiments, the wireless sensor comprises a radio frequency identification (RFID) sensor. In this way, the RFID sensors may be powered up in a passive way by corresponding antennas included in the wireless sensing system, and the RFID sensor does not have a power source circuit but uses energy harvesting by wireless radio frequency power instead; or the RFID sensors may be powered up in an active way by a small current transformer (CT) on a secondary outlet of the CT included in the switchgear, or a battery. Therefore, the wireless sensors of the wireless sensing system may be powered up by internal sources in a more reliable way.

As an example useful for understanding the present disclosure, a method for monitoring a switchgear is provided, the method comprising: sensing a first temperature of a fix contact of a circuit breaker in the switchgear to generate a first sensor signal representing the first temperature by a first set of one or more wireless sensors, wherein the circuit breaker is provided in a first compartment of the switchgear, the first set of one or more wireless sensors are provided in the first compartment and are mounted to the fix contact by a sensor holder, the sensor holder is adapted to fix the first set of one or more wireless sensors between the fix contact and the sensor holder; and receiving the first sensor signal from the first set of one or more wireless sensors by a first antenna provided in the first compartment.

In some embodiments, the switchgear further comprises a second compartment and a bus bar provided in the second compartment, and the method further comprises: sensing a second temperature of the bus bar to generate a second sensor signal representing the second temperature by a second set of one or more wireless sensors, wherein the second set of one or more wireless sensors are provided in the second compartment and are mounted to the bus bar; and receiving the second sensor signal from the second set of one or more wireless sensors by a second antenna provided in the second compartment.

In some embodiments, the switchgear further comprises a third compartment and a cable connection provided in the third compartment, and the method further comprises: sensing a third temperature of the cable connection to generate a third sensor signal representing the third temperature by a third set of one or more wireless sensors, wherein the third set of one or more wireless sensors are provided in the third compartment and are mounted to the cable connection; and receiving the third sensor signal from the third set of one or more wireless sensors by a third antenna provided in the third compartment.

In some embodiments, the switchgear further comprises a fourth compartment, and the method further comprises: receiving the sensor signals from the first antenna, the second antenna, and the third antenna by a reader provided in the fourth compartment.

In some embodiments, the method further comprises: sensing a fourth temperature of the tulips of the circuit breaker to generate a fourth sensor signal representing the fourth temperature by a fourth set of one or more wireless sensors, wherein the fourth set of one or more wireless sensors are provided in the first compartment and are mounted to tulips of the circuit breaker; and receiving the fourth sensor signal from the fourth set of one or more wireless sensors by the first antenna.

In some embodiments, the method further comprises: sensing a current of the circuit breaker to generate a fifth sensor signal representing the current of the circuit breaker by a fifth set of one or more wireless sensors provided in the first compartment; and receiving the fifth sensor signal from the fifth set of one or more wireless sensors by the first antenna.

In some embodiments, the method further comprises: monitoring the switchgear based at least on the first sensor signal and the fifth sensor signal.

In some embodiments, the wireless sensor comprises a radio frequency identification (RFID) sensor.

In a second aspect, embodiments of the present disclosure provide a method of mounting one or more wireless sensors to a switchgear, according to claim 11.

In a third aspect, embodiments of the present disclosure provide an Internet of Things (IoT) system comprising the wireless sensing system described above.

According to embodiments of the present disclosure, the wireless sensing systems senses the temperature and/or the current of the circuit breaker by the wireless sensors in the circuit breaker compartment, so that the switchgear is monitored based on the temperature and/or the current of the circuit breaker. Further, the wireless sensing system further senses the temperatures of the bus bar and the cable connection by the wireless sensors in the bus bar compartment and the cable connection compartment, respectively, so that the switchgear is further monitored based on the temperatures of the bus bar and the cable connection. Therefore, the wireless sensing system is able to monitor the switchgear to pre-alarm potential failures based on suitable operating parameters, without altering the structure of the switchgear.

The wireless sensing system includes the wireless sensors powered up by internal sources and read out by wireless communications in the respective compartments, which facilitates a more reliable monitoring with a low safety risk. The wireless system is easy to be installed in the switchgear and easy to be replaced. The wireless sensing system utilizes the sensors identified by unique ID. The wireless sensing system utilizes the sensor holder for improving the thermal coupling between the wireless sensor and the fix contact of the circuit breaker. Therefore, the wireless sensing system according to the embodiments of the present disclosure improves monitoring reliability for the switchgear and ensures the safety of the switchgear.

### BRIEF DESCRIPTION OF THE DRAWINGS

Embodiments are shown and illustrated with reference to the drawings. The drawings serve to illustrate the basic principle, so that only aspects necessary for understanding the basic principle are illustrated. The drawings are not to scale. In the drawings the same reference characters denote like features. For a more complete understanding of the present invention, and the advantages thereof, reference is now made to the following descriptions taken in conjunction with the accompanying drawings, in which:
Fig. 1A illustrates a block diagram of a switchgear and a wireless sensing system according to an embodiment of the present disclosure;
Fig. 1B illustrates a front view of a switchgear according to an embodiment of the present disclosure;
Fig. 1C illustrates a schematic diagram of a cross-sectional side view of a wireless sensing system for a switchgear according to an embodiment of the present disclosure;
Fig. 2 illustrates a schematic diagram of a cross-sectional rear view of installations of wireless sensors of a wireless sensing system for a switchgear according to an embodiment of the present disclosure;
Fig. 3A illustrates a schematic diagram of a part of a circuit breaker of a switchgear according to an embodiment of the present disclosure;
Fig. 3B illustrates a schematic diagram of an installation of a wireless sensor on a fix contact according to an embodiment of the present disclosure;
Fig. 3C illustrates a schematic diagram of an installation of a wireless sensor on tulips according to an embodiment of the present disclosure;
Fig. 4A illustrates a schematic diagram of a sensor holder according to an embodiment of the present disclosure;
Fig. 4B illustrates a schematic diagram of a sensor holder having wireless sensors placed therein according to an embodiment of the present disclosure;
Fig. 5 illustrates a thermal conductive coating and a field grading layer applied to a wireless sensor according to an embodiment of the present disclosure;
Fig. 6A illustrates a wireless current sensor of a wireless sensing system according to an embodiment of the present disclosure;
Fig. 6B illustrates a wireless current sensor of a wireless sensing system according to another embodiment of the present disclosure;
Fig. 6C illustrates a wireless current sensor of a wireless sensing system according to yet another embodiment of the present disclosure;
Fig. 7A illustrates an placement of an antenna of a wireless sensing system for a switchgear according to an embodiment of the present disclosure;
Fig. 7B illustrates an placement of an antenna of a wireless sensing system for a switchgear according to another embodiment of the present disclosure;
Fig. 8 illustrates placements of antennas of a wireless sensing system for a switchgear according to an embodiment of the present disclosure;
Fig. 9 illustrates a plot depicting temperature measurements according to an embodiment of the present disclosure;
Fig. 10 illustrates a flow chart of a method of mounting wireless sensors to a switchgear according to an embodiment of the present disclosure;
Fig. 11 illustrates a flow chart of a method of monitoring a switchgear according to an embodiment of the present disclosure; and
Fig. 12 illustrates a block diagram of an Internet of Things system according to an embodiment of the present disclosure.

### DETAILED DESCRIPTION

The subject matter described herein will now be discussed with reference to several example embodiments. These embodiments are discussed only for the purpose of enabling those skilled persons in the art to better understand and thus implement the subject matter described herein, rather than suggesting any limitations on the scope of the subject matter.

The term "comprises" or "includes" and its variants are to be read as open terms that mean "includes, but is not limited to." The term "or" is to be read as "and/or" unless the context clearly indicates otherwise. The term "based on" is to be read as "based at least in part on." The term "one embodiment" and "an embodiment" are to be read as "at least one embodiment." The term "another embodiment" is to be read as "at least one other embodiment." Unless specified or limited otherwise, the terms "mounted," "connected," "supported," and "coupled" and variations thereof are used broadly and encompass direct and indirect mountings, connections, supports, and couplings. Furthermore, "connected" and "coupled" are not restricted to physical or mechanical connections or couplings. In the description below, like reference numerals and labels are used to describe the same, similar or corresponding parts in the Figures. Other explicit and implicit definitions may be included below.

As mentioned above, it is desired to provide a sensing system for the switchgear, which has an improved configuration and does not alter a structure of the switchgear. To this point, embodiments of the present disclosure provide a wireless sensing system for the switchgear. The wireless sensing system may include several sets of one or more wireless sensors provided in separate compartments of the switchgear and corresponding antennas provided in respective compartments. According to embodiments of the present disclosure, the wireless sensing system facilitates the reliable monitoring for the switchgear and ensures the safety of the switchgear.

Hereinafter, embodiments of the present disclosure will be described in detail.

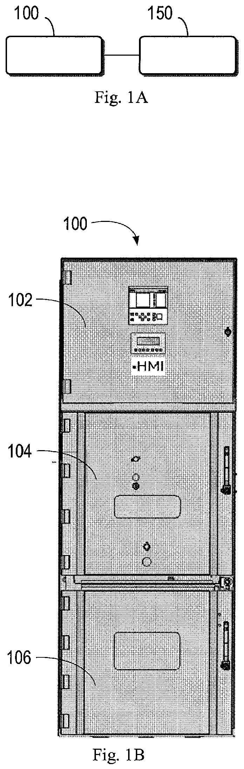

Fig. 1A illustrates a block diagram of the switchgear and the wireless sensing system according to an embodiment of the present disclosure. As shown in Fig. 1A, the switchgear 100 is monitored by the wireless sensing system 150. The wireless sensing system 150 is coupled to the switchgear 100 to sense desired operating parameters of the switchgear 100.

The switchgear 100 includes any known component, such as a circuit breaker. In some embodiments, the switchgear 100 further includes a bus bar and a cable connection. In some embodiments, for example, the switchgear 100 may be a primary switchgear. In other embodiments, the switchgear 100 may be any of other suitable types of switchgears.

The wireless sensing system 150 includes at least one wireless sensor and at least one antenna to receive a sensed signal from the wireless sensor. In some embodiments, the wireless sensing system 150 further includes a reader to receive the signal from the antenna. In some embodiments, the wireless sensing system 150 may include or may be coupled to a control system for monitoring operating parameters of the switchgear 100.

In some embodiments, the wireless sensing system 150 may include passive wireless sensors, such as passive radio frequency identification (RFID) sensors. In this case, for example, the passive RFID sensors may be powered up by corresponding antennas included in the wireless sensing system 150. In other words, the RFID sensor does not have a power source circuit but uses energy harvesting by wireless radio frequency power instead. Alternatively, in other embodiments, the wireless sensing system 150 may include active wireless sensors, such as active RFID sensors. In this case, for example, the active RFID sensors may be powered up by a small current transformer (CT) on a secondary outlet of the CT included in the switchgear 100, or a battery. It should be noted that in yet other embodiments, the wireless sensing system 150 may include other suitable kinds of wireless sensors, such as near field communication (NFC) sensors, etc. In this way, the wireless sensing system 150 is able to read out the operating parameters of the switchgear 100 via a RF communication or other wireless communication by use of relatively stable power supplies within the switchgear 100, thereby improving monitoring reliability for the switchgear and ensuring the safety of the switchgear.

Moreover, in some embodiments, the wireless sensing system 150 may be configured to sense temperatures of the switchgear 100 and to monitor the switchgear 100 based on the sensed temperatures. Alternatively, in other embodiments, the wireless sensing system 150 may be configured to sense a current of the switchgear 100 and to monitor the switchgear 100 based on the sensed current. Alternatively, in yet other embodiments, the wireless sensing system 150 may be configured to sense the temperatures as well as the current of the switchgear 100 and to monitor the switchgear 100 based on a combination of the sensed temperatures and the sensed current. It should be noted that in still other embodiments, the wireless sensing system 150 may include other kinds of sensors to sense other operating parameters of the switchgear 100, such as acoustic/noise sensor, vibration sensor, magnetic field sensor, etc. In this way, the wireless sensing system 150 is able to sense any appropriate parameter of the switchgear 100 and to monitor the switchgear 100 based on any individual parameter or combination thereof, thereby improving monitoring reliability.

Fig. 1B illustrates a front view of a switchgear according to an embodiment of the present disclosure. In general, the switchgear 100 includes an enclosure, such as metal-clad enclosure, for housing the switchgear components. The enclosure may include one or more separate compartments. As shown in Fig. 1A, the switchgear 100 includes a monitoring compartment 102, a circuit breaker compartment 104, and a cable connection compartment 106. The monitoring compartment 102 includes one or more instruments that are configured to present or display operating parameters of the switchgear 100 to users. The circuit breaker compartment 104 includes a circuit breaker of the switchgear 100. The cable connection compartment 106 includes a cable connection of the switchgear 100. In some embodiments, the compartment includes a metallic shield space.

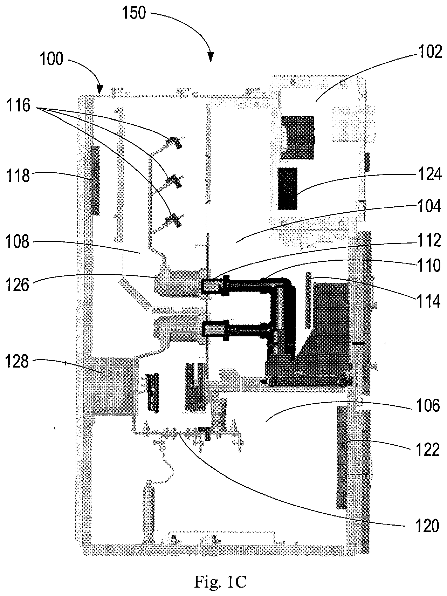

Fig. 1C illustrates a schematic diagram of a cross-sectional side view of a wireless sensing system for the switchgear according to an embodiment of the present disclosure. The wireless sensing system 150 includes wireless sensors, antennas, and a reader provided in the switchgear 100. As shown in Fig. 1C, in addition to the compartments 102, 104, 106, the switchgear 100 further includes a bus bar compartment 108.

The switchgear 100 includes the circuit breaker 110 provided in the circuit breaker compartment (hereinafter referred to as a "first compartment") 104. In some embodiments, the circuit breaker 100 is a three-pole draw-out type circuit breaker. The switchgear 100 may include one or more circuit breakers 110. For example, in some embodiments, the switchgear 100 may include 3×2 circuit breakers 110 for three phases. It should be noted that in other embodiments, the switchgear 100 may include other numbers of the circuit breakers 110. In some embodiments, the circuit breaker 110 includes a fix contact 112. The wireless sensing system 150 includes wireless sensors provided in the first compartment 104 and a first antenna 114 provided in the first compartment 104. The first antenna 114 may be configured to receive sensed signals from the wireless sensors provided in the first compartment 104.

In addition, in some embodiment, the switchgear 100 further includes a bus bar 116 provided in the bus bar compartment (hereinafter referred to as a "second compartment") 108. In some embodiments, for example, the switchgear 100 may include three bus bars 116 for three phases. It should be noted that in other embodiments, the switchgear 100 may include other numbers of the bus bars 116. The wireless sensing system 150 may further include wireless sensors provided in the second compartment 108 and a second antenna 118 provided in the second compartment 108. The second antenna 118 may be configured to receive sensed signals from the wireless sensors provided in the second compartment 108.

In some embodiments, the fix contact 112 of the circuit breaker 110 is electrically connected to a contact supported by a conductor bushing 126 which is connected to the bus bar 116. In this way, the circuit breaker 110 is electrically coupled to the bus bar 116 via the conductor bushing 126.

Referring to Fig. 1C, during a normal operation of the switchgear 100, the fix contact 112 of the circuit breaker 100 is electrically coupled to the bus bar 116 via the conductor bushing 126 provided in the second compartment 108. That is, the fix contact 112 is pushed into the conductor bushing 126 to be electrically coupled to the bus bar 116. At least a portion of the conductor bushing 126 is generally enclosed by insulating material. As a result, since the fix contact 112 is pushed into the conductor bushing 126 provided in the second compartment 108 during the normal operation, the second antenna 118 may further receive sensed signals from the wireless sensors mounted to the fix contact 112, in addition to the one or more wireless sensors mounted to the bus bar 116. In this way, not only the first antenna 114 but also the second antenna 118 may receive the sensor signals from the wireless sensors mounted to the fix contact 112, thereby obtaining more samples of the sensed signals and improving the sensing accuracy of the circuit breaker 110.

Moreover, in some embodiments, the switchgear 100 further includes the cable connection 120 provided in the cable connection compartment (hereinafter referred to as a "third compartment") 106. In some embodiments, for example, the switchgear 100 may include three cable connections 120 for three phases. It should be noted that in other embodiments, the switchgear 100 includes other numbers of the cable connections 120. The wireless sensing system 150 may further include wireless sensors provided in the third compartment 106 and a third antenna 122 provided in the third compartment 106. The third antenna 122 may be configured to receive sensed signals from the wireless sensors provided in the third compartment 106.

In some embodiments, the wireless sensing system 150 further includes a reader 124 provided in the monitoring compartment 102. In some embodiments, the reader 124 may be configured to receive signals from the first antenna 114, the second antenna 118, and the third antenna 122. In this way, the users may easily obtain desired parameters from the reader in the monitoring compartment 102.

In some embodiments, the switchgear 100 further includes a phase voltage transformer (PT) or current transformer (CT) 128. In some embodiments, the wireless sensing system 150 may further include wireless sensors provided at the PT/CT 128 to sense the parameters of the PT/CT 128.

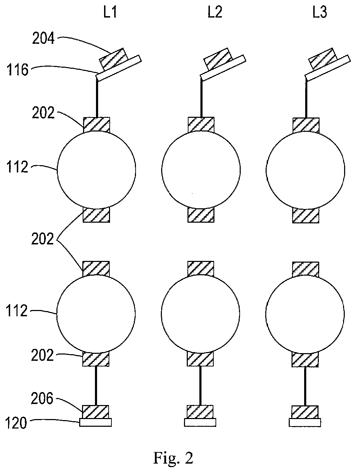

Fig. 2 illustrates a schematic diagram of a cross-sectional rear view of installations of the wireless sensors of the wireless sensing system 150 for the switchgear according to an embodiment of the present disclosure.

As shown in Figs. 1C and 2, the wireless sensing system 150 includes a first set of one or more wireless sensors 202 provided in the first compartment 104. In some embodiments, the first set of one or more wireless sensors 202 are mounted to the fix contacts 112 of the circuit breakers 110. In some embodiments, for example, the switchgear 100 includes 3×2 circuit breakers 110 for three phases L1, L2, L3. In some embodiments, the first set of one or more wireless sensors 202 includes at least one wireless sensor 202 mounted to each fix contact 112 of the circuit breaker 110. Although Fig. 2 illustrates that there are two wireless sensors 202 mounted to each fix contact 112, it is to be understood that the present disclosure is not limited thereto. In other embodiments, other numbers of the wireless sensors 202 may be mounted to each fix contact 112, or different numbers of the wireless sensors 202 may be mounted the respective fix contacts 112.

In some embodiments, the first set of one or more wireless sensors 202 are configured to sense a first temperature of the fix contact 112 to generate a first sensor signal representing the first temperature. In some embodiments, the first antenna 114 may be configured to receive the first sensor signal for the fix contact 112 from the first set of one or more wireless sensors 202. In this way, the wireless sensing system 150 senses and monitors the temperature of the fix contact 112 of the circuit breaker 110 in the first compartment 104, by the first set of one or more wireless sensors 202 and the first antenna 114 provided in the first compartment 104.

In addition, in some embodiments, the wireless sensing system 150 may further include a second set of one or more wireless sensors 204 provided in the second compartment 108. In some embodiments, the second set of one or more wireless sensors 204 are mounted to the bus bars 116. In some embodiments, the second set of one or more wireless sensors 204 includes at least one wireless sensor 204 mounted to the bus bar 116 for each of three phases L1, L2, L3.

In some embodiments, the second set of one or more wireless sensors 204 are configured to sense a second temperature of the bus bar 116 to generate a second sensor signal representing the second temperature. In some embodiments, the second antenna 118 may be configured to receive the second sensor signal for the bus bar 116 from the second set of one or more wireless sensors 204. In this way, the wireless sensing system 150 senses and monitors the temperature of the bus bar 116 of the switchgear 100 in the second compartment 108, by the second set of one or more wireless sensors 204 and the second antenna 118 provided in the second compartment 108. As described above, the second antenna 118 may be further configured to receive the first sensor signal from the first set of one or more wireless sensors 202, so that more measurement samples of the fix contact 112 may be obtained.

In some embodiments, the wireless sensing system 150 may further include a third set of one or more wireless sensors 206 provided in the third compartment 106. In some embodiments, the third set of one or more wireless sensors 206 are mounted to the cable connections 120. In some embodiments, the third set of one or more wireless sensors 206 includes at least one wireless sensor 206 mounted to the cable connection 120 for each of three phases L1, L2, L3.

In some embodiments, the third set of one or more wireless sensors 206 are configured to sense a third temperature of the cable connection 120 to generate a third sensor signal representing the third temperature. In some embodiments, the third antenna 122 may be configured to receive the third sensor signal for the cable connection 120 from the third set of one or more wireless sensors 206. In this way, the wireless sensing system 150 senses and monitors the temperature of the cable connection 120 of the switchgear 100 in the third compartment 106, by the third set of one or more wireless sensors 206 and the third antenna 122 provided in the third compartment 106.

In some embodiments, the sets of one or more wireless sensors 202, 204, 206 may include RFID temperature sensors. The RFID temperature sensor may include an RFID sensor integrated circuit (IC) provided with a thermistor and an RF antenna coupled to the RFID sensor IC, and a working frequency of RFID may be in range of UHF. It should be noted that in other embodiments, the wireless sensing system 150 may include any other type of RFID temperature sensors known in the art.

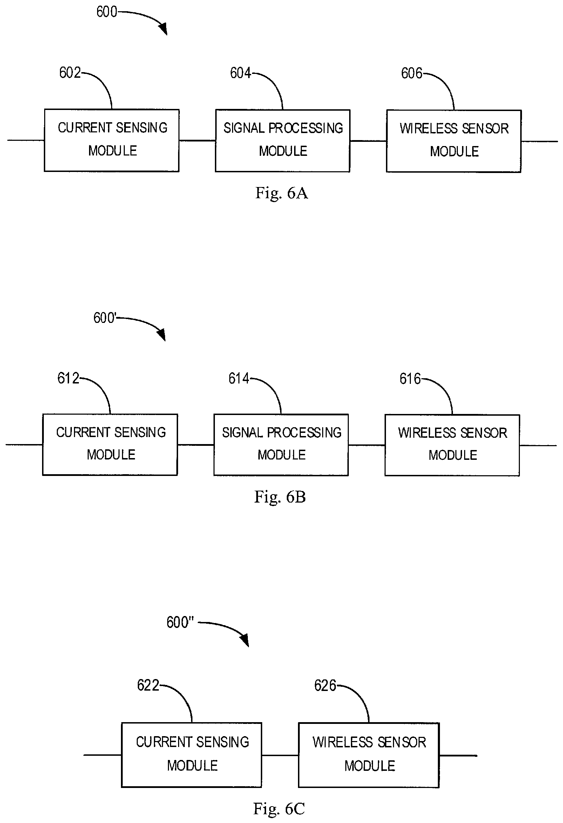

Alternatively, or in addition, the wireless sensing system 150 may include a further set of one or more wireless sensors provided in the first compartment 104, the further set of one or more wireless sensors may be configured to sense a current of the circuit breaker 110 to generate an output signal representing the current, which will be described in detail below with reference to Figs. 6A-6C. In some embodiments, the further set of one or more wireless sensors may be provided anywhere within the first compartment 104. In some embodiments, the first antenna 114 may be configured to receive the current signal from the further set of one or more wireless sensors in the first compartment 104. In this way, the wireless sensing system 150 senses and monitors the current of the circuit breaker 110 of the switchgear 100 in the first compartment 104, by the further set of one or more wireless sensors and the first antenna 114 provided in the first compartment 104.

In some embodiments, the wireless sensing system 150 monitors the switchgear 100 based at least on a combination of the first sensor signal (i.e. temperature signal) and the current signal of the circuit breaker 110. In this way, the switchgear 100 is monitored based on a more comprehensive aspect to improve the monitoring reliability and the monitoring accuracy.

Hereinafter, embodiments of installations of the wireless sensors to the circuit breaker will be described in detail.

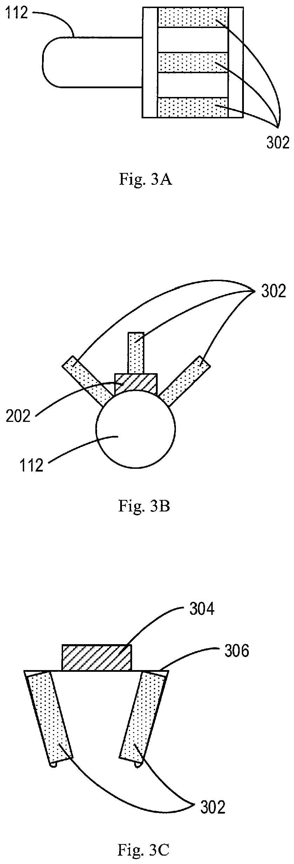

Fig. 3A illustrates a schematic diagram of a part of the circuit breaker of the switchgear according to an embodiment of the present disclosure. In addition to the fix contact 112, in some embodiments, the circuit breaker 110 further includes a plurality of metallic tulips 302. The fix contact 112 and the tulips 302 of the circuit breaker 110 are well known in the art, and detailed descriptions thereof are omitted herein.

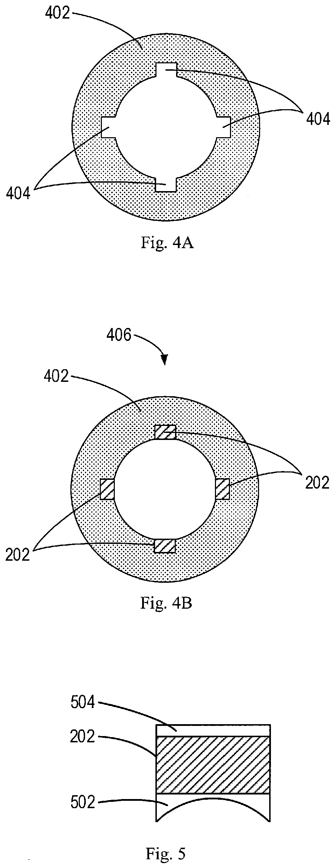

Fig. 3B illustrates a schematic diagram of an installation of the wireless sensor on the fix contact according to an embodiment of the present disclosure. The first set of one or more wireless sensors 202 are mounted to an outer annular surface of the fix contact 112 without altering the structure of the fix contact 112. In some embodiments, the first set of one or more wireless sensors 202 are mounted to the surface of the fix contact 112 with the aid of a sensor holder, which will be described later with reference to Figs. 4A and 4B.

Fig. 3C illustrates a schematic diagram of an installation of the wireless sensor on the tulips according to an embodiment of the present disclosure. In some embodiments, the wireless sensing system 150 may further include a fourth set of one or more wireless sensors 304 provided in the first compartment 104, and one or more sensor supports 306 attached to the tulips 302 of the circuit breaker 110. In some embodiments, each one of the fourth set of one or more wireless sensors 304 is mounted to a surface of the corresponding sensor support 306. In some embodiments, the fourth set of one or more wireless sensors 304 may be configured to sense a fourth temperature of the tulips 302 of the circuit breaker 110 to generate a fourth sensor signal representing the fourth temperature. In some embodiments, the first antenna 114 may be further configured to receive the fourth sensor signal from the fourth set of one or more wireless sensors 304. In this way, the temperature measurements at more points of the circuit breaker 110 may be obtained, thereby improving the monitoring reliability and accuracy.

In some embodiments, the sensor support 306 may be attached to side surfaces of two adjacent tulips 302, so as to be thermally coupled to the two adjacent tulips 302, as shown in Fig. 3C. In this case, each one of the fourth set of one or more wireless sensors 304 is configured to sense the temperature of the two adjacent tulips 302. In other embodiments, the sensor support 306 may be attached to side surfaces of another number of tulips 302, and each one of the fourth set of one or more wireless sensors 304 is configured to sense the temperature of the another number of tulips 302.

Fig. 4A illustrates a schematic diagram of a sensor holder according to an embodiment of the present disclosure. In some embodiments, the sensor holder 402 may have a ring shape. In some embodiments, the sensor holder 402 has an inner diameter matched with or similar to an outer diameter of the fix contact 112. In this way, a sliding fit may be made between the sensor holder 402 and the fix contact 112. In addition, in some embodiments, the sensor holder 402 has a thickness larger that of the wireless sensor. In this way, the sensor holder improves a holding reliability of the wireless sensors.

In some embodiments, the sensor holder 402 may be made of hard material, for example. In some embodiments, the sensor holder 402 comprises polymeric material, such as PVDF, TP, etc. Moreover, in some embodiments, the sensor holder 402 may include one or more grooves 404 provided in an inner surface of the sensor holder 402. In some embodiments, the grooves 404 are adaptive to receive the first set of one or more wireless sensors 202, so that the first set of one or more wireless sensors 202 are placed at the surface of the sensor holder 402 facing the fix contact 112. In other words, the sensor holder 402 is adaptive to fix the first set of one or more wireless sensors 202 between the fix contact 112 and the sensor holder 402. In this way, the sensor holder 402 supports the wireless sensor 202 in contact with the fix contact 112, thereby ensuring a stable installation of the wireless sensors to the fix contact 112, and improving a thermal coupling between the wireless sensor 202 and the fix contact 112.

It should be noted that although Fig. 4A shows an embodiment in which the sensor holder 402 includes four grooves 404, other embodiments may include any other number of grooves 404.

Fig. 4B illustrates a schematic diagram of the sensor holder having the wireless sensors placed therein according to an embodiment of the present disclosure. As shown in Fig. 4B, in some embodiments, a sensor assembly 406 includes the sensor holder 402 and the first set of one or more wireless sensors 202 placed in the grooves 404 of the sensor holder 402. In some embodiments, the wireless sensor 202 is fully accommodated in the groove 404, so that the sensor assembly 406 has the same inner diameter as the sensor holder 402. In this case, the sensor assembly 406 has the inner diameter substantially equivalent to the outer diameter of the fix contact 112. Alternatively, in other embodiments, the wireless sensor 202 is partially accommodated in the groove 404, so that a portion of the wireless sensor 202 protrudes from the inner surface of the sensor holder 402. In this case, the sensor assembly 406 has the inner diameter smaller than that of the sensor holder 402, and the sensor assembly 406 has the inner diameter substantially equivalent to the outer diameter of the fix contact 112. In this way, the sliding fit is ensured between the sensor assembly 406 and the fix contact 112.

In some embodiments, the sensor assembly 406 is adaptive to be pushed onto the fix contact 112, so that an outer surface of the wireless sensor 202 is in contact with the fix contact 112. In some embodiments, The sensor assembly 406 is adaptive to move from an end of the fix contact 112 toward an inner side of the fix contact 112 with the fix contact 112 being coaxially inserted into a hollow space of the ring-shaped sensor holder 402. After the sensor assembly 406 is installed to the fix contact 112, the circuit breaker 110 may be installed to the switchgear as usual. In this way, the sensor assembly 406 of the wireless sensing system 150 may be mounted to the fix contact 112 of the circuit breaker 110 without altering the structure of the fix contact 112 of the circuit breaker 110 which is known in the art.

Fig. 5 illustrates a thermal conductive coating and a field grading layer applied to a wireless sensor according to an embodiment of the present disclosure. In some embodiments, the thermal conductive coating 502 may be provided at the surface of the wireless sensor 202 exposed by the sensor holder 402. The thermal conductive coating 502 may be provided between the wireless sensor 202 and the fix contact 112, so that a thermal resistance between the wireless sensor 202 and the fix contact 112 may be reduced. In this way, better thermal contact and more accurate measurement may be made by the thermal conductive coating 502.

Moreover, in some embodiments, the field grading layer 504 may be provided on a surface of the wireless sensor 202 facing the sensor holder 402, e.g., the surface opposite to the mounting surface of the wireless sensor 202 to the fix contact 112, as shown in Fig. 5. In other embodiments, the field grading layer 504 may be provided on an outer surface of the sensor holder 402, i.e., an outer surface of the sensor assembly 406. The field grading layer 504 may be configured to grade the electrical field reaching the wireless sensor 202. In this way, the first set of one or more wireless sensors 202 are shield by the field grading layer 504, thereby improving the reliability of the wireless sensor and improving the accuracy of the measurement.

The above description made with reference to Figs. 3A-3C, Figs. 4A-4B, and Fig. 5 illustrates the installation of the first set of one or more wireless sensors 202 on the fix contact 112 of the circuit breaker 110 provided in the first compartment 104, and the installation of the fourth set of one or more wireless sensors 304 on the tulips 302 of the circuit breaker 110. Regarding the installations of the second set of one or more wireless sensors 204 and the third set of one or more wireless sensors 206, the wireless sensors 204 and the wireless sensors 206 may be respectively attached to the bus bar 116 and the cable connection 120 directly or via intermediate layer, or by any other suitable manner in the art.

As described above, the wireless sensing system 150 may include the further set of one or more wireless sensors configured to sense the current of the circuit breaker 110 to generate the output signal representing the current. In some embodiments, the further set of one or more wireless sensors may be provided anywhere within the first compartment 104.

Hereinafter, configurations of the further set of one or more wireless sensors, i.e. wireless current sensors, will be described in detail.

Fig. 6A illustrates the wireless current sensor of the wireless sensing system according to an embodiment of the present disclosure. In some embodiments, the wireless current sensor 600 includes a current sensing module 602, a signal processing module 604, and a wireless sensor module 606. In some embodiments, the wireless current sensor 600 includes a passive wireless sensor.

In some embodiments, the current sensing module 602 may be configured to sense the current of the circuit breaker 110 to generate an AC current signal. In some embodiments, the current sensing module 602 is coupled to the circuit breaker 110 of the switchgear 100 to sense the current of the circuit breaker 110. In some embodiments, the current sensing module 602 includes a current induction component, e.g., a current transformer.

In some embodiments, the signal processing module 604 may be configured to generate a DC current signal or a DC voltage signal based on the AC current signal. In some embodiments, the signal processing module 604 is coupled to the current sensing module 602 to receive the AC current signal from the current sensing module 602. In some embodiments, the signal processing module 604 includes a regulating and signal converting component, e.g., an AC to DC converter or rectifier. In some embodiments, the signal processing module 604 may further include an amplifier for signal amplification.

In some embodiments, the wireless sensor module 606 may be configured to generate the output signal based on the DC current signal or the DC voltage signal. In some embodiments, the wireless sensor module 606 is coupled to the signal processing module 604 to receive the DC current signal or the DC voltage signal from the signal processing module 604. In some embodiments, the output signal generated by the wireless sensor module 606 is wirelessly received by the first antenna 114 provided in the first compartment 104. In some embodiments, the wireless sensor module 606 includes a sensor component and a wireless communication component. In some embodiments, the wireless sensor module 606 includes a passive wireless sensor module. In some embodiments, the wireless sensor module 606 includes an RFID sensor module. In this case, the RFID sensor module includes an RFID sensor configured to detect the DC current signal or the DC voltage signal to generate the output signal, and an RF antenna coupled to the RFID sensor and configured to transmit the output signal to the first antenna 114.

Fig. 6B illustrates the wireless current sensor of the wireless sensing system according to another embodiment of the present disclosure. In some embodiments, the wireless current sensor 600' includes a current sensing module 612, a signal processing module 614, and a wireless sensor module 616. In some embodiments, the wireless current sensor 600' includes a passive wireless sensor.

In some embodiments, the current sensing module 612 may be configured to sense the current of the circuit breaker 110 to generate a current signal. In some embodiments, the current sensing module 612 is coupled to the circuit breaker 110 of the switchgear 100 to sense the current of the circuit breaker 110. In some embodiments, the current sensing module 612 includes a current sensing loop or an induction loop provided around a conductor or at a side of the conductor.

In some embodiments, the signal processing module 614 may be configured to generate a resistance signal or an inductance signal based on the current signal. In some embodiments, the signal processing module 614 is coupled to the current sensing module 612 to receive the current signal from the current sensing module 612. In some embodiments, the signal processing module 614 includes a semiconductor circuit, e.g., an amplifier circuit, to convert the current signal to the resistance signal or the inductance signal.

In some embodiments, the wireless sensor module 616 configured to generate the output signal based on the resistance signal or the inductance signal. In some embodiments, the wireless sensor module 616 is coupled to the signal processing module 614 to receive the resistance signal or the inductance signal from the signal processing module 614. In some embodiments, the output signal generated by the wireless sensor module 616 is wirelessly received by the first antenna 114 provided in the first compartment 104. In some embodiments, the wireless sensor module 616 includes a sensor component and a wireless communication component. In some embodiments, the wireless sensor module 616 includes a passive wireless sensor module. In some embodiments, the wireless sensor module 616 includes an RFID sensor module. In this case, the RFID sensor module includes an RFID sensor configured to detect the resistance signal or the inductance signal to generate the output signal, and an RF antenna coupled to the RFID sensor and configured to transmit the output signal to the first antenna 114.

Fig. 6C illustrates the wireless current sensor of the wireless sensing system according to yet another embodiment of the present disclosure. In some embodiments, the wireless current sensor 600" includes a current sensing module 622 and a wireless sensor module 626. In some embodiments, the wireless current sensor 600" includes a passive wireless sensor.

In some embodiments, the current sensing module 622 may be configured to sense the current of the circuit breaker (110) to generate a sensed current signal. In some embodiments, the current sensing module 622 is coupled to the circuit breaker 110 of the switchgear 100 to sense the current of the circuit breaker 110. In some embodiments, the current sensing module 622 includes a Hall effect sensor, Rogowski coil, etc.

In some embodiments, the wireless sensor module 626 configured to generate the output signal based on the sensed current signal. In some embodiments, the wireless sensor module 626 is coupled to the current sensing module 622 to receive the sensed current signal from the current sensing module 622. In some embodiments, the output signal generated by the wireless sensor module 626 is wirelessly received by the first antenna 114 provided in the first compartment 104. In some embodiments, the wireless sensor module 616 includes a sensor component and a wireless communication component. In some embodiments, the wireless sensor module 626 includes a passive wireless sensor module. In some embodiments, the wireless sensor module 626 includes an RFID sensor module. In this case, the RFID sensor module includes an RFID sensor configured to detect the sensed current signal to generate the output signal, and an RF antenna coupled to the RFID sensor and configured to transmit the output signal to the first antenna 114.

In some embodiments, the wireless sensor module 606, 616, 626 may further include a protection component, such as a diode, a transient voltage suppressor, etc., for preventing overvoltage or breakdown of the sensor component, e.g. the RFID sensor.

By arranging the further set of one or more wireless sensors 600, 600', 600" in the first compartment 104 to sense the current of the circuit breaker 110, the switchgear 100 may be monitored based on the current of the circuit breaker 110, in addition to or as an alternative to the temperature of the circuit breaker 110. In some embodiments, the switchgear 100 is monitored based on the combination of the temperature and the current of the circuit breaker 110 by the first set of one or more wireless sensors 202 and the further set of one or more wireless sensors 600, 600', 600" which are both provided in the first compartment 104. In this way, the switchgear 100 may be monitored in a more comprehensive scheme to facilitate reliable and accurate monitoring of the circuit breaker 110, thereby ensuring the safety of the switchgear 100.

As mentioned above, the sensed temperature and current of the circuit breaker 110 may be received by the first antenna 114 provided in the first compartment 104. Hereinafter, a placement of the first antenna 114 in the first compartment 104 will be described in detail.

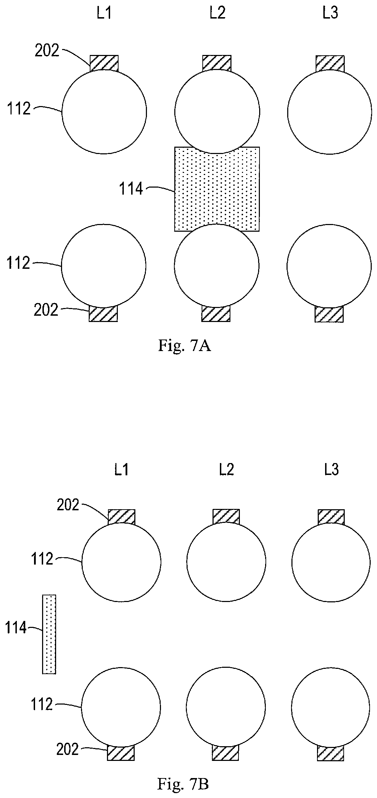

Fig. 7A illustrates an installation of the antenna of the wireless sensing system for the switchgear according to an embodiment of the present disclosure. As shown in Fig. 7A, the wireless sensing system 150 includes the first set of one or more wireless sensors 202 mounted to the fix contact 112, and the first antenna 114, which are provided in the first compartment 104. Referring to Figs. 1C and 7A, in some embodiments, the first antenna 114 is placed on an inner sidewall at a side of the first compartment 104 opposite to another side where the first set of one or more wireless sensors 202 are provided. In other words, the first antenna 114 is placed on the inner sidewall of the first compartment 104 close to the front side of the switchgear 100. In some embodiments, the first antenna 114 is a single antenna. In some embodiments, the first antenna 114 is configured to receive the sensor signals of 3×2 circuit breakers 110 for three phases L1, L2, L3, as shown in Fig. 7A. In other embodiments, the first antenna 114 may be configured to receive the sensor signals of other numbers of circuit breakers 110. Moreover, in some embodiments, the first antenna 114 may be placed on a central portion of a region of the sidewall that includes projections of the circuit breakers 110 or the fix contacts 112 on the sidewall.

Fig. 7B illustrates an installation of the antenna of the wireless sensing system for the switchgear according to another embodiment of the present disclosure. The embodiment of Fig. 7B differs from that of Fig. 7A in that the first antenna 114 is placed on another sidewall of the first compartment 104. Referring to Figs. 1C and 7B, in some embodiments, the first antenna 114 is placed on an inner sidewall at a side of the first compartment 104 adjacent to another side where the first set of one or more wireless sensors 202 are provided. In other words, the first antenna 114 is placed on the inner sidewall of the first compartment 104 adjacent to the sidewall close to the front side of the switchgear 100.

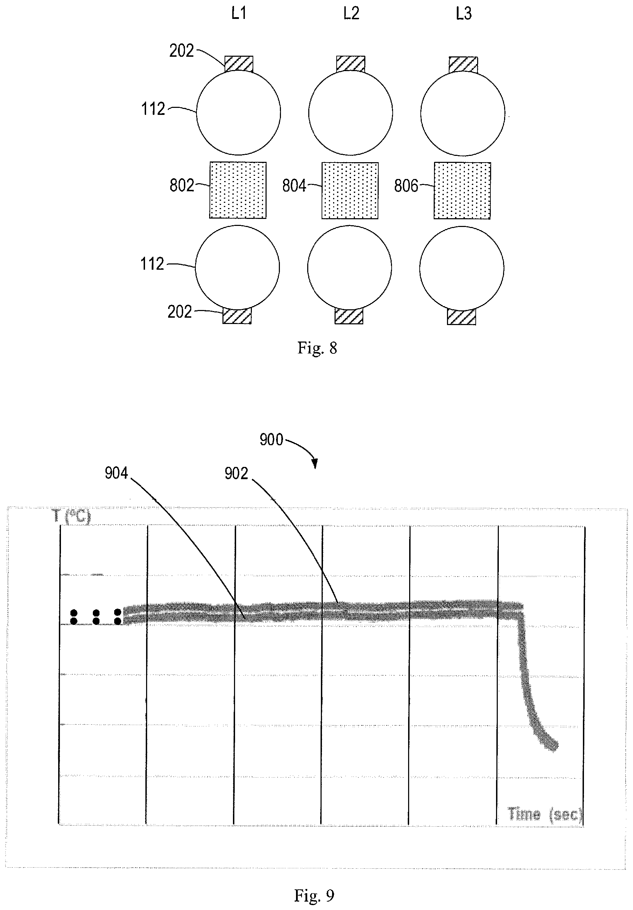

Fig. 8 illustrates placements of antennas of the wireless sensing system for the switchgear according to an embodiment of the present disclosure. The embodiment of Fig. 8 differs from that of Fig. 7A in that the first antenna 114 consists of three sub-structures. As shown in Fig. 8, in some embodiments, the first antenna 114 includes a first sub-antenna 802, a second sub-antenna 804, and a third sub-antenna 806 which are provided in the first compartment 104. In some embodiments, the first sub-antenna 802, the second sub-antenna 804, and the third sub-antenna 806 are placed on the inner sidewall at the side of the first compartment 104 opposite to another side where the first set of one or more wireless sensors 202 are provided. In other words, the first sub-antenna 802, the second sub-antenna 804, and the third sub-antenna 806 are placed on the inner sidewall of the first compartment 104 close to the front side of the switchgear 100.

In some embodiments, the first sub-antenna 802, the second sub-antenna 804, and the third sub-antenna 806 may be configured to receive the sensor signals for three phases L1, L2, L3 of the switchgear 100, respectively. In this way, each of the circuit breakers 110 is individually monitored for the corresponding phase of the switchgear 100 based on the respective sensor signal received by the corresponding sub-antennas. Therefore, signal losses and interferences of the received sensor signals by the respective sub-antennas are minimized, thereby improving the monitoring reliability and the monitoring accuracy of the switchgear 100.

Additionally, in some embodiments, the wireless sensing system 150 may further include the fourth set of one or more wireless sensors 304 mounted to the tulips 302 of the circuit breaker 110, which are provided in the first compartment 104 and are not shown in Figs. 7A-7B and 8. In addition, or alternatively, the wireless sensing system 150 may further include the further set of one or more wireless 600, 600', 600" configured to sense the current of the circuit breaker 110, which are provided in the first compartment 104 and are not shown in Figs. 7A-7B and 8. In some embodiments, the first antenna 114 shown in Figs. 7A-7B and 8 may be further configured to receive the sensor signals from the fourth set of one or more wireless sensors 304 and/or the further set of one or more wireless 600, 600', 600", in addition to the sensor signal from the first set of one or more wireless sensors 202 shown in Figs. 7A-7B and 8.

Regarding the placements of the second antenna 118 and the third antenna 122, in some embodiments, the second antenna 118 and the third antenna 122 may be placed at any suitable part of inner walls of the second compartment 108 and the third compartment 106, respectively, as long as signal losses of the received sensor signals by the second compartment 108 and the third compartment 106 are minimized. In other embodiments, the second antenna 118 and the third antenna 122 may be formed as an integral antenna filled in an opening of a wall between the second compartment 108 and the third compartment 106. In this way, the structure of the wireless sensing system 150 may be simplified.

Fig. 9 illustrates a plot depicting temperature measurements according to an embodiment of the present disclosure. As shown in Fig. 9, the plot 900 includes a curve 902 representing the measured temperatures of the switchgear 100 by conventional thermocouples, and a curve 904 representing the measured temperatures of the switchgear 100 by the wireless sensing system 150 according to embodiments of the present disclosure.

In the plot 900, the temperature measurements at beginning phases are omitted for ease of description. From the plot 900, a difference between the measured temperatures represented by the curve 902 and the curve 904 is less than 5 °C for a certain period of time, which may be mainly caused by pre-calibration of the sensor. Therefore, the wireless sensing system 150 according to embodiments of the present disclosure may provide the temperature measurements of the switchgear 100 as accurate as the thermocouples for the certain period of time, during which the thermocouples are not affected by external influences. Further, the wireless sensing system 150 has a more reliable working scheme and is easy to install and replace. Therefore, the wireless sensing system 150 ensures the monitoring reliability and accuracy for the switchgear and the safety of the switchgear for a long lifetime.

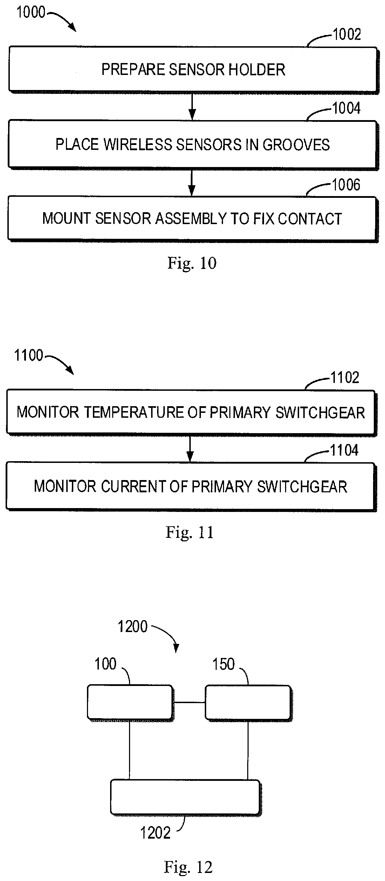

Fig. 10 illustrates a flow chart of a method of mounting the wireless sensors to the switchgear according to an embodiment of the present disclosure. Specifically, the flow chart 1000 illustrates the method of mounting the first set of one or more wireless sensors 202 to the fix contact 112 of the circuit breaker 110.

At block 1002, the sensor holder 402 is prepared. The sensor holder 402 has the ring shape and includes the grooves 404 provided at the inner surface, as shown in Fig. 4A.

At block 1004, the wireless sensors 202 are placed in the grooves 404 to form the sensor assembly 406, as shown in Fig. 4B.

At block 1006, the sensor assembly 406 is mounted to the fix contact 112. The fix contact 112 is coaxially inserted into the sensor assembly 406, and at least one of outer surfaces of the wireless sensors 202 is in contact with the fix contact 112.

The method of flow chart 1000 enables the first set of one or more wireless sensors 202 to be mounted to the fix contact 112 without altering the structure of the circuit breaker 110, thereby facilitating monitoring the switchgear by the wireless sensing system 150. The method may be performed in any suitable manner in the art, such as robots under control, etc.

Fig. 11 illustrates a flow chart of a method of monitoring the switchgear according to an embodiment of the present disclosure. The flow chart 1100 of the method of monitoring the switchgear 100 by the wireless sensing system 150 may include actions or processes of the respective sets of one or more wireless sensors of the wireless sensing system 150 as described above.

At block 1102, the temperature of the switchgear 100 is monitored. Specifically, the temperature of the fix contact 112 of the circuit breaker 110 in the first compartment 104 is monitored by the first set of one or more wireless sensors 202 and the first antenna 114 provided in the first compartment 104. In some embodiments, the temperature of the bus bar 116 in the second compartment 108 is further monitored by the second set of one or more wireless sensors 204 and the second antenna 118 provided in the second compartment 108. In some embodiments, the temperature of the cable connection 120 in the third compartment 106 is further monitored by the third set of one or more wireless sensors 206 and the third antenna 122 provided in the third compartment 106. In some embodiments, the temperature of the tulips 302 of the circuit breaker 110 in the first compartment 104 is further monitored by the fourth set of one or more wireless sensors 304 and the first antenna 114 provided in the first compartment 104.

At block 1104, the current of the switchgear 100 is monitored. Specifically, the current of the circuit breaker 110 in the first compartment 104 is monitored by the further set of one or more wireless sensors 600, 600', 600" and the first antenna 114 provided in the first compartment 104.

In some embodiments, the circuit breaker 110 of the switchgear 100 is monitored based on the combination of the temperature and the current, thereby providing the more reliable and accurate monitoring scheme with more comprehensive aspect.

It should be noted that the method of monitoring the switchgear 100 may be implemented in an order different from that shown in the flow chart 1100, or may include either of actions at block 1102 or block 1104.

Fig. 12 illustrates a block diagram of an Internet of Things (IoT) system according to an embodiment of the present disclosure. As shown in Fig. 12, the IoT system 1200 includes the wireless sensing system 150 described in above embodiments. In the IoT system 1200, the wireless sensing system 150 is connected to a control system 1202 of the IoT system 1200 via a wired or wireless communication. In some embodiments, more than one wireless sensing system 150 may be included in the IoT system 1200 and connected to the control system 1202. In some embodiments, more than one switchgear 100 may be included in the IoT system 1200 and connected to the control system 1202 via a wired or wireless communication.

In some embodiments, the control system 1202 may be configured to monitor the operating parameters of the switchgear 100 sensed by the wireless sensing system 150. In some embodiments, the control system 1202 may be further configured to control operations of the wireless sensing system 150, and/or operations of the switchgear 100.

While several details are contained in the above discussions, these should not be construed as limitations on the scope of the subject matter described herein, but rather as descriptions of features that may be specific to particular embodiments. Certain features that are described in the context of separate embodiments may also be implemented in combination in a single embodiment. On the other hand, various features that are described in the context of a single embodiment may also be implemented in multiple embodiments separately or in any suitable sub-combination.

Although the subject matter has been described in language specific to structural features, it is to be understood that the subject matter defined in the appended claims is not necessarily limited to the specific features described above. Rather, the specific features described above are disclosed as example forms of implementing the claims. In light of this, the scope of the present disclosure should not be limited to that of the particular embodiments illustrated and described herein, as they are merely by way of some examples thereof, but rather, should be fully commensurate with that of the claims appended hereafter.

## Claims

1. A wireless sensing system (150) and a switchgear (100), the wireless sensing system (150) comprising:
a second set of one or more wireless sensors (202) provided in a first compartment (104) of the switchgear (100) and mounted to a fix contact (112) of a circuit breaker (110) in the switchgear (100), the second set of one or more wireless sensors (202) being configured to sense a temperature of the fix contact (112) to generate a second sensor signal representing the temperature of the fix contact (112);
a sensor holder (402) having a ring shape, wherein the second set of one or more wireless sensors (202) is mounted to the fix contact (112) of the circuit breaker (110) by the sensor holder (402), wherein the circuit breaker (110) is provided in the first compartment (104), and the sensor holder (402) is configured to fix the second set of one or more wireless sensors (202) between the fix contact (112) and the sensor holder (402);
the wireless sensing system further comprising:
a first antenna (114) provided in the first compartment (104) and configured to receive the second sensor signal from the second set of one or more wireless sensors (202).

2. The wireless sensing system (150) and the switchgear (100) of claim 1, further comprising:
a first set of one or more wireless sensors (600, 600', 600") provided in the first compartment (104) and configured to sense a current of the circuit breaker (110) to generate a first sensor signal representing the current of the circuit breaker (110),
wherein each of the first set of one or more wireless sensors (600) comprises:
a current sensing module (602) configured to sense the current of the circuit breaker (110) to generate a sensed signal, a current signal or an AC current signal;
a signal processing module (604), if the current sensing module (602) is configured to generate a current signal or an AC current signal, the signal processing module (604) is configured to generate a resistance or inductance signal based on the current signal, or to generate a DC current or voltage signal based on the AC current signal; and
a wireless sensor module (606) configured to generate the first sensor signal based on the sensed signal, based on the resistance or inductance signal, or based on the DC current or voltage signal,
wherein the first antenna (114) is configured to receive the first sensor signal from the first set of one or more wireless sensors (600, 600', 600").

3. The wireless sensing system (150) and the switchgear (100) of claim 2, wherein each of the first set of one or more wireless sensors (600, 600', 600") comprises a passive wireless sensor and/or
wherein the switchgear (100) is monitored based on the first sensor signal and the second sensor signal.

4. The wireless sensing system (150) and the switchgear (100) of claim 1, wherein the sensor holder (402) comprises at least one groove (404) for placing the second set of one or more wireless sensors (202) at a surface of the sensor holder (402) facing the fix contact (112) and comprising in particular a ring shaped hard structure, and
wherein the sensor holder (402) in particular comprises a ring shaped hard structure that has an inner diameter matching with an outer diameter of the fix contact (112).

5. The wireless sensing system (150) and the switchgear (100) of any of claims 1 to 4, wherein the first antenna (114) comprises a first sub-antenna (802), a second sub-antenna (804), and a third sub-antenna (806) for receiving the sensor signals for three phases of the switchgear (100), respectively.

6. The wireless sensing system (150) and the switchgear (100) of claim 1, further comprising:
a thermally conductive coating (502) provided between the fix contact (112) and the second set of one or more wireless sensors (202) for reducing a thermal resistance between the fix contact (112) and the first set of one or more wireless sensors (202); or
the wireless sensing system further comprising
a field grading layer (504) provided on at least one of surfaces of the second set of one or more wireless sensors (202) facing the sensor holder (402) or an outer surface of the sensor holder (402) for shielding the second set of one or more wireless sensors (202).

7. The wireless sensing system (150) and the switchgear (100) of claim 1, wherein the switchgear (100) further comprises a second compartment (108) and a bus bar (116) provided in the second compartment (108), and the wireless sensing system (150) further comprises:
a further second set of one or more wireless sensors (204), in particular a bus bar set of one or more wireless sensors (204), to be provided in the second compartment (108) and mounted to the bus bar (116), the further second set of one or more wireless sensors (204) being configured to sense a second temperature of the bus bar (116) to generate a further second sensor signal representing the second temperature; and
a second antenna (118) provided in the second compartment (108) and configured to receive the further second sensor signal from the further second set of one or more wireless sensors (204);
wherein the second antenna (118) is in particular further configured to receive the second sensor signal from the second set of one or more wireless sensors (202).

8. The wireless sensing system (150) and the switchgear (100) of claim 7, wherein the switchgear (100) further comprises a third compartment (106) and a cable connection (120) provided in the third compartment (106), and the wireless sensing system (150) further comprises:
a third set of one or more wireless sensors (206) provided in the third compartment (106) and mounted to the cable connection (120), the third set of one or more wireless sensors (206) being configured to sense a third temperature of the cable connection (120) to generate a third sensor signal representing the third temperature; and
a third antenna (122) provided in the third compartment (106) and configured to receive the third sensor signal from the third set of one or more wireless sensors (206).

9. The wireless sensing system (150) and the switchgear (100) of claim 1 or 8, wherein the switchgear (100) further comprises a fourth compartment (102), and the wireless sensing system (150) further comprises:
a reader (124) provided in the fourth compartment (102) and configured to receive the sensor signals from the first antenna (114), the second antenna (118), and the third antenna (122),
and/or
wherein the wireless sensing system further comprising:
a fourth set of one or more wireless sensors (304) provided in the first compartment (104) and mounted to tulips (302) of the circuit breaker (110), the fourth set of one or more wireless sensors (304) being configured to sense a fourth temperature of the tulips (302) of the circuit breaker (110) to generate a fourth sensor signal representing the fourth temperature,
wherein the first antenna (114) is further configured to receive the fourth sensor signal from the fourth set of one or more wireless sensors (304).

10. The wireless sensing system (150) and the switchgear (100) of any of claims 1 to 9, wherein the wireless sensor (202, 204, 206, 304, 600, 600', 600") comprises a radio frequency identification, RFID, sensor.

11. A method of mounting the wireless sensing system (150) of any of the previous claims to the switchgear (100) of any of the previous claims, the method comprising:
preparing the sensor holder (402) having a ring shape and comprising at least one groove (404) provided at an inner surface thereof;
placing the one or more wireless sensors (202) in the at least one groove (404) to form a sensor assembly (406); and
mounting the sensor assembly (406) to a fix contact (112) of a circuit breaker (110) in the switchgear (100) so that the fix contact (112) is coaxially inserted into the sensor assembly (406) and at least one of outer surfaces of the one or more wireless sensors (202) is in contact with the fix contact (112).

12. An Internet of Things, IoT, system (1200) comprising:
the wireless sensing system (150) and the switchgear (100) according to any of claims 1 to 10.

## Patentansprüche

1. Drahtloses Erfassungssystem (150) und Schaltanlage (100), wobei das drahtlose Erfassungssystem (150) umfasst:
einen zweiten Satz von einem oder mehreren drahtlosen Sensoren (202), die in einem ersten Fach (104) der Schaltanlage (100) vorgesehen und an einem festen Kontakt (112) eines Leistungsschalters (110) in der Schaltanlage (100) angebracht sind, wobei der zweite Satz von einem oder mehreren drahtlosen Sensoren (202) konfiguriert ist, um eine Temperatur des festen Kontakts (112) zu erfassen, um ein zweites Sensorsignal zu erzeugen, das die Temperatur des festen Kontakts (112) darstellt;
einen Sensorhalter (402), der eine Ringform aufweist, wobei der zweite Satz von einem oder mehreren drahtlosen Sensoren (202) durch den Sensorhalter (402) an dem festen Kontakt (112) des Leistungsschalters (110) angebracht wird, wobei der Leistungsschalter (110) in dem ersten Fach (104) vorgesehen ist und der Sensorhalter (402) konfiguriert ist, um den zweiten Satz von einem oder mehreren drahtlosen Sensoren (202) zwischen dem festen Kontakt (112) und dem Sensorhalter (402) zu befestigen; das drahtlose Erfassungssystem ferner umfassend:
eine erste Antenne (114), die in dem ersten Fach (104) vorgesehen ist und konfiguriert ist, um das zweite Sensorsignal von dem zweiten Satz von einem oder mehreren drahtlosen Sensoren (202) zu empfangen.

2. Drahtloses Erfassungssystem (150) und Schaltanlage (100) nach Anspruch 1, ferner umfassend:
einen ersten Satz von einem oder mehreren drahtlosen Sensoren (600, 600', 600''), die in dem ersten Fach (104) vorgesehen sind und konfiguriert sind, um einen Strom des Leistungsschalters (110) zu erfassen, um ein erstes Sensorsignal zu erzeugen, das den Strom des Leistungsschalters (110) darstellt,
wobei jeder von dem ersten Satz von einem oder mehreren drahtlosen Sensoren (600) umfasst:
ein Stromerfassungsmodul (602), das konfiguriert ist, um den Strom des Leistungsschalters (110) zu erfassen, um ein erfasstes Signal, ein Stromsignal oder ein Wechselstromsignal zu erzeugen;
ein Signalverarbeitungsmodul (604), wobei, wenn das Stromerfassungsmodul (602) konfiguriert ist, um ein Stromsignal oder ein Wechselstromsignal zu erzeugen, das Signalverarbeitungsmodul (604) konfiguriert ist, um ein Widerstands- oder Induktivitätssignal basierend auf dem Stromsignal oder ein Gleichstrom- oder Spannungssignal basierend auf dem Wechselstromsignal zu erzeugen; und
ein drahtloses Sensormodul (606), das konfiguriert ist, um das erste Sensorsignal basierend auf dem erfassten Signal, basierend auf dem Widerstands- oder Induktivitätssignal oder basierend auf dem Gleichstrom- oder Spannungssignal zu erzeugen,
wobei die erste Antenne (114) konfiguriert ist, um das erste Sensorsignal von dem ersten Satz von einem oder mehreren drahtlosen Sensoren (600, 600', 600") zu empfangen.

3. Drahtloses Sensorsystem (150) und Schaltanlage (100) nach Anspruch 2, wobei jeder aus dem ersten Satz von einem oder mehreren drahtlosen Sensoren (600, 600', 600") einen passiven drahtlosen Sensor umfasst, und/oder wobei die Schaltanlage (100) basierend auf dem ersten Sensorsignal und dem zweiten Sensorsignal überwacht wird.

4. Drahtloses Sensorsystem (150) und Schaltanlage (100) nach Anspruch 1, wobei der Sensorhalter (402) mindestens eine Nut (404) zum Platzieren des zweiten Satzes von einem oder mehreren drahtlosen Sensoren (202) auf einer Oberfläche des Sensorhalters (402) umfasst, die dem festen Kontakt (112) zugewandt ist und insbesondere eine harte ringförmige Struktur umfasst, und
wobei der Sensorhalter (402) insbesondere eine harte ringförmige Struktur umfasst, die einen Innendurchmesser aufweist, der zu einem Außendurchmesser des festen Kontakts (112) passt.

5. Drahtloses Sensorsystem (150) und Schaltanlage (100) nach einem der Ansprüche 1 bis 4, wobei die erste Antenne (114) jeweils eine erste Unterantenne (802), eine zweite Unterantenne (804) und eine dritte Unterantenne (806) zum Empfangen der Sensorsignale für drei Phasen der Schaltanlage (100) umfasst.

6. Drahtloses Erfassungssystem (150) und Schaltanlage (100) nach Anspruch 1, ferner umfassend:
eine wärmeleitende Beschichtung (502), die zwischen dem festen Kontakt (112) und dem zweiten Satz von einem oder mehreren drahtlosen Sensoren (202) vorgesehen ist, um einen Wärmewiderstand zwischen dem festen Kontakt (112) und dem ersten Satz von einem oder mehreren drahtlosen Sensoren (202) zu verringern; oder
das drahtlose Erfassungssystem ferner umfassend eine Feldsteuerungsschicht (504), die auf mindestens einer der Oberflächen des zweiten Satzes von einem oder mehreren drahtlosen Sensoren (202), die dem Sensorhalter (402) zugewandt sind, oder einer Außenfläche des Sensorhalters (402) zum Abschirmen des zweiten Satzes von einem oder mehreren drahtloser Sensoren (202) vorgesehen sind.

7. Drahtloses Erfassungssystem (150) und Schaltanlage (100) nach Anspruch 1, wobei die Schaltanlage (100) ferner ein zweites Fach (108) und eine im zweiten Fach (108) vorgesehene Sammelschiene (116) umfasst und das drahtlose Erfassungssystem (150) ferner umfasst:
einen weiteren zweiten Satz von einem oder mehreren drahtlosen Sensoren (204), insbesondere einen Sammelschienensatz von einem oder mehreren drahtlosen Sensoren (204), die in dem zweiten Fach (108) vorgesehen sein sollen und an der Sammelschiene (116) angebracht werden, wobei der weitere zweite Satz von einem oder mehreren drahtlosen Sensoren (204) konfiguriert ist, um eine zweite Temperatur der Sammelschiene (116) zu erfassen, um ein weiteres zweites Sensorsignal zu erzeugen, das die zweite Temperatur darstellt; und
eine zweite Antenne (118), die in dem zweiten Fach (108) vorgesehen und konfiguriert ist, um das weitere zweite Sensorsignal von dem weiteren zweiten Satz von einem oder mehreren drahtlosen Sensoren (204) zu empfangen;
wobei die zweite Antenne (118) insbesondere ferner konfiguriert ist, um das zweite Sensorsignal von dem zweiten Satz von einem oder mehreren drahtlosen Sensoren (202) zu empfangen.

8. Drahtloses Erfassungssystem (150) und Schaltanlage (100) nach Anspruch 7, wobei die Schaltanlage (100) ferner ein drittes Fach (106) und eine im dritten Fach (106) vorgesehene Kabelverbindung (120) umfasst und das drahtlose Erfassungssystem (150) ferner umfasst:
einen dritten Satz von einem oder mehreren drahtlosen Sensoren (206), die in dem dritten Fach (106) vorgesehen sind und an der Kabelverbindung (120) angebracht werden, wobei der dritte Satz von einem oder mehreren drahtlosen Sensoren (206) konfiguriert ist, um eine dritte Temperatur der Kabelverbindung (120) zu erfassen, um ein drittes Sensorsignal zu erzeugen, das die dritte Temperatur darstellt; und
eine dritte Antenne (122), die in dem dritten Fach (106) vorgesehen ist und konfiguriert ist, um das dritte Sensorsignal von dem dritten Satz von einem oder mehreren drahtlosen Sensoren (206) zu empfangen.

9. Drahtloses Erfassungssystem (150) und Schaltanlage (100) nach Anspruch 1 oder 8, wobei die Schaltanlage (100) ferner ein viertes Fach (102) umfasst und das drahtlose Erfassungssystem (150) ferner umfasst:
ein Lesegerät (124), das im vierten Fach (102) vorgesehen ist und konfiguriert ist, um die Sensorsignale von der ersten Antenne (114), der zweiten Antenne (118) und der dritten Antenne (122) zu empfangen,
und/oder
wobei das drahtlose Erfassungssystem ferner umfasst:
einen vierten Satz von einem oder mehreren drahtlosen Sensoren (304), die in dem ersten Fach (104) vorgesehen und an den Tulpenkontakten (302) des Leistungsschalters (110) angebracht werden, wobei der vierte Satz von einem oder mehreren drahtlosen Sensoren (304) konfiguriert ist, um eine vierte Temperatur der Tulpenkontakte (302) des Leistungsschalters (110) zu erfassen, um ein viertes Sensorsignal zu erzeugen, das die vierte Temperatur darstellt, und
wobei die erste Antenne (114) ferner konfiguriert ist, um das vierte Sensorsignal von dem vierten Satz von einem oder mehreren drahtlosen Sensoren (304) zu empfangen.

10. Drahtloses Erfassungssystem (150) und Schaltanlage (100) nach einem der Ansprüche 1 bis 9, wobei der drahtlose Sensor (202, 204, 206, 304, 600, 600', 600") einen Radiofrequenz-Identifikations (RFID)-Sensor umfasst.

11. Verfahren zur Anbringung des drahtlosen Sensorsystems (150) nach einem der vorherigen Ansprüche an der Schaltanlage (100) nach einem der vorherigen Ansprüche, das Verfahren umfassend:
Vorbereiten des Sensorhalters (402), der eine Ringform aufweist und mindestens eine Nut (404) umfasst, die an seiner Innenfläche vorgesehen ist;
Platzieren des einen oder der mehreren drahtlosen Sensoren (202) in der mindestens einen Nut (404), um eine Sensoranordnung (406) zu bilden; und
Anbringen der Sensoranordnung (406) an einem festen Kontakt (112) eines Leistungsschalters (110) in der Schaltanlage (100), sodass der feste Kontakt (112) koaxial in die Sensoranordnung (406) eingeführt wird und mindestens eine von einer der Außenflächen des einen oder der mehreren drahtlosen Sensoren (202) in Kontakt mit dem festen Kontakt (112) sind.

12. Internet der Dinge (IoT)-System (1200), umfassend:
das drahtlose Erfassungssystem (150) und die Schaltanlage (100) nach einem der Ansprüche 1 bis 10.

## Revendications

1. Système de détection sans fil (150) et appareillage de commutation (100), le système de détection sans fil (150) comprenant :
un deuxième ensemble d'un ou de plusieurs capteurs sans fil (202) prévu dans un premier compartiment (104) de l'appareillage de commutation (100) et monté sur un contact fixe (112) d'un coupe-circuit (110) dans l'appareillage de commutation (100), le deuxième ensemble d'un ou de plusieurs capteurs sans fil (202) étant configuré pour détecter une température du contact fixe (112) pour générer un deuxième signal de capteur représentant la température du contact fixe (112) ;
un support de capteur(s) (402) présentant une forme d'anneau, dans lequel le deuxième ensemble d'un ou de plusieurs capteurs sans fil (202) est monté sur le contact fixe (112) du coupe-circuit (110) au moyen du support de capteur(s) (402), dans lequel le coupe-circuit (110) est prévu dans le premier compartiment (104), et le support de capteur(s) (402) est configuré pour fixer le deuxième ensemble d'un ou de plusieurs capteurs sans fil (202) entre le contact fixe (112) et le support de capteur(s) (402) ;
le système de détection sans fil comprenant en outre :
une première antenne (114) prévue dans le premier compartiment (104) et configurée pour recevoir le deuxième signal de capteur en provenance du deuxième ensemble d'un ou de plusieurs capteurs sans fil (202).

2. Système de détection sans fil (150) et appareillage de commutation (100) selon la revendication 1, comprenant en outre :
un premier ensemble d'un ou de plusieurs capteurs sans fil (600, 600', 600") prévu dans le premier compartiment (104) et configuré pour détecter un courant du coupe-circuit (110) pour générer un premier signal de capteur représentant le courant du coupe-circuit (110) ;
dans lequel chacun du premier ensemble d'un ou de plusieurs capteurs sans fil (600) comprend :
un module de détection de courant (602) configuré pour détecter le courant du coupe-circuit (110) pour générer un signal détecté, un signal de courant ou un signal de courant AC ;
un module de traitement de signal (604), si le module de détection de courant (602) est configuré pour générer un signal de courant ou un signal de courant AC, le module de traitement de signal (604) est configuré pour générer un signal de résistance ou d'inductance sur la base du signal de courant, ou pour générer un signal de courant ou de tension DC sur la base du signal de courant AC ; et
un module de capteur sans fil (606) configuré pour générer le premier signal de capteur sur la base du signal détecté, sur la base du signal de résistance ou d'inductance ou sur la base du signal de courant ou de tension DC ;
dans lequel la première antenne (114) est configurée pour recevoir le premier signal de capteur en provenance du premier ensemble d'un ou de plusieurs capteurs sans fil (600, 600', 600").

3. Système de détection sans fil (150) et appareillage de commutation (100) selon la revendication 2, dans lequel chacun du premier ensemble d'un ou de plusieurs capteurs (600, 600', 600") comprend un capteur sans fil passif et/ou
dans lequel l'appareillage de commutation (100) est surveillé sur la base du premier signal de capteur et du deuxième signal de capteur.

4. Système de détection sans fil (150) et appareillage de commutation (100) selon la revendication 1, dans lequel le support de capteur(s) (402) comprend au moins une gorge (404) pour placer le deuxième ensemble d'un ou de plusieurs capteurs sans fil (202) au niveau d'une surface du support de capteur(s) (402) qui fait face au contact fixe (112) et qui comprend en particulier une structure dure en forme d'anneau ; et
dans lequel le support de capteur(s) (402) comprend en particulier une structure dure en forme d'anneau qui présente un diamètre interne qui correspond à un diamètre externe du contact fixe (112).

5. Système de détection sans fil (150) et appareillage de commutation (100) selon l'une quelconque des revendications 1 à 4, dans lequel la première antenne (114) comprend une première sous-antenne (802), une deuxième sous-antenne (804) et une troisième sous-antenne (806) pour recevoir respectivement les signaux de capteur pour trois phases de l'appareillage de commutation (100).

6. Système de détection sans fil (150) et appareillage de commutation (100) selon la revendication 1, comprenant en outre :
un revêtement thermiquement conducteur (502) prévu entre le contact fixe (112) et le deuxième ensemble d'un ou de plusieurs capteurs sans fil (202) pour réduire une résistance thermique entre le contact fixe (112) et le premier ensemble d'un ou de plusieurs capteurs sans fil (202) ; ou
le système de détection sans fil comprenant en outre :
une couche de gradation de champ (504) prévue sur au moins une surface de surfaces du deuxième ensemble d'un ou de plusieurs capteurs sans fil (202) faisant face au support de capteur(s) (402) ou une surface externe du support de capteur(s) (402) pour protéger le deuxième ensemble d'un ou de plusieurs capteurs sans fil (202).

7. Système de détection sans fil (150) et appareillage de commutation (100) selon la revendication 1, dans lequel l'appareillage de commutation (100) comprend en outre un deuxième compartiment (108) et un busbar (116) prévu dans le deuxième compartiment (108), et le système de détection sans fil (150) comprend en outre :
un autre deuxième ensemble d'un ou de plusieurs capteurs sans fil (204), en particulier un ensemble pour busbar d'un ou de plusieurs capteurs sans fil (204), destiné à être prévu dans le deuxième compartiment (108) et monté sur le busbar (116), l'autre deuxième ensemble d'un ou de plusieurs capteurs sans fil (204) étant configuré pour détecter une deuxième température du busbar (116) pour générer un autre deuxième signal de capteur représentant la deuxième température ; et
une deuxième antenne (118) prévue dans le deuxième compartiment (108) et configurée pour recevoir l'autre deuxième signal de capteur en provenance de l'autre deuxième ensemble d'un ou de plusieurs capteurs sans fil (204) ;
dans lequel la deuxième antenne (118) est en particulier en outre configurée pour recevoir le deuxième signal de capteur en provenance du deuxième ensemble d'un ou de plusieurs capteurs sans fil (202).

8. Système de détection sans fil (150) et appareillage de commutation (100) selon la revendication 7, dans lequel l'appareillage de commutation (100) comprend en outre un troisième compartiment (106) et une connexion par câble (120) prévue dans le troisième compartiment (106), et le système de détection sans fil (150) comprend en outre :
un troisième ensemble d'un ou de plusieurs capteurs sans fil (206) prévu dans le troisième compartiment (106) et monté sur la connexion par câble (120), le troisième ensemble d'un ou de plusieurs capteurs sans fil (206) étant configuré pour détecter une troisième température de la connexion par câble (120) pour générer un troisième signal de capteur représentant la troisième température ; et
une troisième antenne (122) prévue dans le troisième compartiment (106) et configurée pour recevoir le troisième signal de capteur en provenance du troisième ensemble d'un ou de plusieurs capteurs sans fil (206).

9. Système de détection sans fil (150) et appareillage de commutation (100) selon la revendication 1 ou 8, dans lequel l'appareillage de commutation (100) comprend en outre un quatrième compartiment (102), et le système de détection sans fil (150) comprend en outre :
un lecteur (124) prévu dans le quatrième compartiment (102) et configuré pour recevoir les signaux de capteur en provenance de la première antenne (114), de la deuxième antenne (118) et de la troisième antenne (122) ;
et/ou
dans lequel le système de détection sans fil comprenant en outre :
un quatrième ensemble d'un ou de plusieurs capteurs sans fil (304) prévu dans le premier compartiment (104) et monté sur des tulipes (302) du coupe-circuit (110), le quatrième ensemble d'un ou de plusieurs capteurs sans fil (304) étant configuré pour détecter une quatrième température des tulipes (302) du coupe-circuit (110) pour générer un quatrième signal de capteur représentant la quatrième température ;
dans lequel la première antenne (114) est en outre configurée pour recevoir le quatrième signal de capteur en provenance du quatrième ensemble d'un ou de plusieurs capteurs sans fil (304).

10. Système de détection sans fil (150) et appareillage de commutation (100) selon l'une quelconque des revendications 1 à 9, dans lequel le capteur sans fil (202, 204, 206, 304, 600, 600', 600") comprend un capteur d'identification radiofréquence, RFID.

11. Procédé de montage du système de détection sans fil (150) selon l'une quelconque des revendications précédentes sur l'appareillage de commutation (100) selon l'une quelconque des revendications précédentes, le procédé comprenant :
la préparation du support de capteur(s) (402) présentant une forme d'anneau et comprenant au moins une gorge (404) prévue au niveau de sa surface interne ;
le placement des un ou plusieurs capteurs sans fil (202) dans l'au moins une gorge (404) pour former un assemblage de capteur(s) (406) ; et
le montage de l'assemblage de capteur(s) (406) sur le contact fixe (112) d'un coupe-circuit (110) dans l'appareillage de commutation (100) de telle sorte que le contact fixe (112) soit inséré de façon coaxiale à l'intérieur de l'assemblage de capteur(s) (406) et qu'au moins l'une de surfaces externes des un ou plusieurs capteurs sans fil (202) soit en contact avec le contact fixe (112).

12. Système de l'Internet des objets, IoT, (1200) comprenant :
le système de détection sans fil (150) et l'appareillage de commutation (100) selon l'une quelconque des revendications 1 à 10.
